# EUROPEAN PATENT APPLICATION

(11) **EP 3 565 095 A1**
(43) Date of publication of application: **06.11.2019**
(21) Application number: 19172326.1
(22) Date of filing: 02.05.2019
(51) Int. Cl.: H02M 1/088, H03K 17/041, H02M 1/00

(54) **REDUCED POWER DISSIPATION POWER CONVERTER CONFIGURATION**

(30) Priority: 01.05.2018 US 201815968209
(71) Applicant: Hamilton Sundstrand Corporation, Charlotte, NC 28217-4578 (US)
(72) Inventor: DICKEY, John A., Rockford, IL 61109 (US)
(74) Representative: Dehns

(57) **Abstract**

A system and method of controlling a power converter (14) that includes at least one first switch of a first switch type (30, 34) and at least one second switch of a second switch type (32, 36), includes converting, by the power converter, an input power at a converter input into output power at a converter output for a load. Converting the input power into the output power includes turning on, by a controller (12), the at least one first switch to conduct current from the converter input to the converter output; and turning on, by the controller, the at least one second switch to conduct current from the converter input to the converter output after a first threshold time period following turn-on of the at least one first switch.

## Description

### BACKGROUND

The present invention relates generally to power converters, and in particular to a method of controlling switches in a power converter.

In electric systems, it is often necessary to convert and condition power. To do so, switching circuits are often utilized and controlled to provide an output power different from an input power. The switches within these converter circuits are traditionally all of the same type, such as a common type of field-effect transistor (FET). This provides a give-and-take depending on which type of FETs are used in the converter design. For example, FETs that have a low on-resistance (Rdsₒₙ) can suffer from slow gate drives and high switching losses due to the high gate charge. On the other hand, FETs that have low gate charge can suffer from high on-resistances, which may result in high conduction losses. It is desirable to design a power converter that suffers from neither of these issues, reducing the overall power dissipation of the converter.

### SUMMARY

In one embodiment, a method of controlling a power converter that includes at least one first switch of a first switch type and at least one second switch of a second switch type, includes converting, by the power converter, an input power at a converter input into output power at a converter output for a load. Converting the input power into the output power includes turning on, by a controller, the at least one first switch to conduct current from the converter input to the converter output; and turning on, by the controller, the at least one second switch to conduct current from the converter input to the converter output after a first threshold time period following turn-on of the at least one first switch.

In another embodiment, a method of controlling power from an input power to a load includes turning on, by a controller, one or more first switches to conduct current from the input power to the load, wherein each of the one or more first switches are of a first switch type; and turning on, by the controller, one or more second switches, connected in parallel with the one or more first switches, to conduct current from the input power to the load after a first threshold time period following turn-on of the one or more first switches, wherein each of the one or more second switches are of a second switch type different from the first switch type.

In another embodiment, a power converter system is configured to convert an input power into an output power for a load and includes a controller, at least one low gate charge switch, and at least one low on-resistance switch connected in parallel with the at least one low gate charge switch. The controller is configured to turn the at least one gate charge switch and the at least one low on-resistance switch on and off to convert the input power to the output power, and turn on the at least one low gate charge switch and the at least one low on-resistance switch by turning on the at least one low gate charge switch, waiting a first threshold time period, and then turning on the at least one low on-resistance switch.

### BRIEF DESCRIPTION OF THE DRAWINGS

FIG. 1 is a block diagram illustrating a power converter circuit having two types of transistors.
FIG. 2 is a circuit diagram illustrating an embodiment of a power converter circuit having two types of field-effect transistors.
FIG. 3 is a timing diagram illustrating drain currents for two types of transistors within a power converter circuit.
FIG. 4 is a flowchart illustrating a method of operating a power converter having two types of transistors.

### DETAILED DESCRIPTION

A power converter is disclosed herein that includes low on-resistance (Rdsₒₙ) switches and low gate charge switches connected in parallel. When turning on the switches, the low gate charge switches are turned on first. Once the low gate charge switches are fully conducting, the low Rdsₒₙ switches are turned on. This way, the low gate charge switches are utilized to make the switching transition, while the low Rdsₒₙ switches are utilized to carry the majority of current. At turn-off, the low Rdsₒₙ switches are initially turned off. Once the low Rdsₒₙ switches have fully turned off, the low gate charge switches are turned off. Turning the switches on and off in this way reduces switching losses and power dissipation within the power converter.

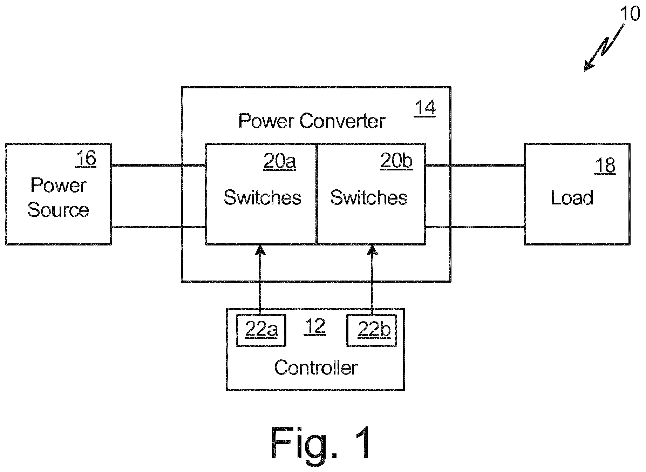

FIG. 1 is a block diagram illustrating power converter system 10 having two types of transistors. System 10 includes controller 12, power converter 14, power source 16, and load 18. Power converter circuit 14 includes switches 20a and 20b. Controller 12 includes gate drives 22a and 22b. Power source 16 can be any alternating current (AC) or direct current (DC) power source and load 18 can be any load that accepts either AC or DC power. Because of this, power converter 14 may be any type of power converter including, but not limited to, DC-to-DC boost or buck converters, AC-to-DC rectifiers, DC-to-AC inverters, or AC-to-AC converters. In one embodiment, power source 16 may be an aircraft DC power bus configured to provide 28V DC power and power converter 14 may be a buck converter configured to step-down the 28V DC power for load 18. Also, while illustrated in FIG. 1 as a power converter system, switches 20a and 20b may also be implemented, for example, in other applications such as motor drives.

Power converter 14 includes at least switches 20a and 20b. While illustrated as two types of switches 20a and 20b, power converter 14 may include other switches and electronic devices. Switches 20a and 20b are controlled by controller 12. Controller 12 may implement any control scheme for power converter 14. For example, controller 12 may control switches 20a and 20b using pulse width modulation (PWM). Controller 12 includes gate drives 22a and 22b utilized to control the signals provided to the gates of respective switches 20a and 20b. While illustrated as two gate drives 22a and 22b, any number of gate drives may be used depending on the needs of the system. Switches 20a may be of a first type, and switches 20b may be of a second type. For example, switches 20a may be low on-resistance (Rdsₒₙ) metal-oxide-semiconductor field-effect transistors (MOSFETs), and switches 20b may be low gate charge MOSFETs.

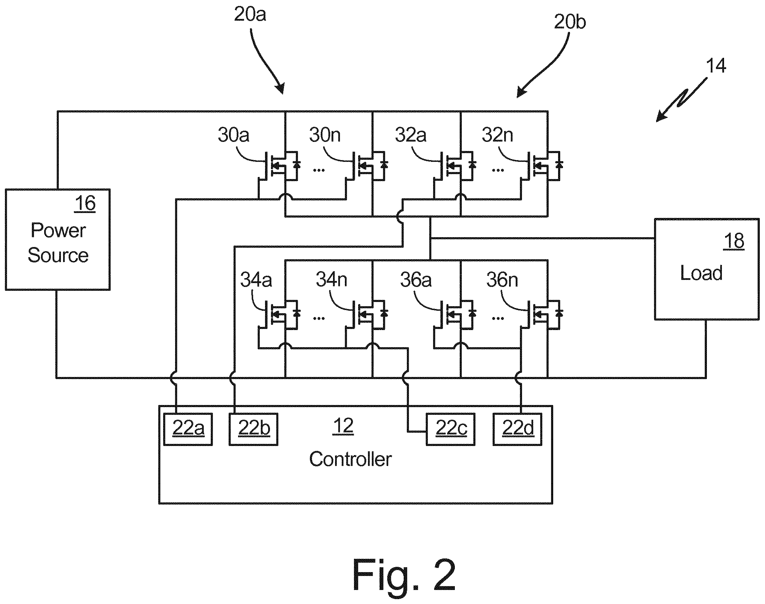

FIG. 2 is a circuit diagram illustrating an example embodiment of power converter circuit 14 having two types of switches. In the embodiment illustrated in FIG. 2, power converter 14 is a half bridge DC-to-DC buck converter. Switches 20a include individual MOSFETs 30a-30n and 34a-34n, and switches 20b include individual MOSFETs 32a-32n and 36a-36n. Power source 16 is a DC power source that provides DC input power to power converter 14. For example, power source 16 may be an aircraft DC power bus. FIG. 2 illustrates a simplified schematic for a buck converter. While not shown, other components, such as inductors and/or capacitors, may be included in power converter 14.

MOSFETs 30a-30n and 32a-32n form a first switching set, and MOSFETs 34a-34n and 36a-36n form a second switching set. While illustrated as a half bridge buck converter that includes two switching sets, power converter 14 may have any converter configuration. For example, in another embodiment, converter 14 may have a full bridge configuration that includes four switching sets rather than the two illustrated in FIG. 2. Each switching set includes a first switch type 20a and a second switch type 20b. For example, MOSFETs 30a-30n and 34a-34n may be low gate charge MOSFETs, while MOSFETs 32a-32n and 36a-36n may be low Rdsₒₙ MOSFETs.

While illustrated as having multiple MOSFETs of each switch type connected in parallel, each switching set may include only one of each switch type. For example, converter 14 may be configured to only include MOSFETs 30a, 32a, 34a, and 36a. Further, in other embodiments, switching sets may include dissimilar numbers of different switch types. For example, the first switching set may include a single low gate charge MOSFET 30a, while including multiple low Rdsₒₙ MOSFETs 32a-32n. In some embodiments, converter 14 may include a single switching set. For example, a boost converter may be implemented using only the first switching set that includes MOSFETs 30a-30n and 32a-32n.

Gate drives 22a-22d are utilized to control the gate voltages for MOSFETs 30a-30n, 32a-32n, 34a-34n, and 36a-36n. Gate drive 22a provides a gate drive signal for all of MOSFETs 30a-30n, gate drive 22b provides a gate drive signal for all of MOSFETS 32a-32n, gate drive 22c provides a gate drive signal for all of MOSFETs 34a-34n, and gate drive 22d provides a gate drive signal for all of MOSFETs 36a-36n. All switches of the same switch type for each switching set can include a shared gate drive signal, as is illustrated in FIG. 2. In other embodiments, multiple different gate drive signals may be provided to each switch type of a switching set. For example, each one of MOSFETs 30a-30n, 32a-32n, 34a-34n, and 36a-36n may include its own respective gate driver in systems that may desire additional switching speed and/or failure modes.

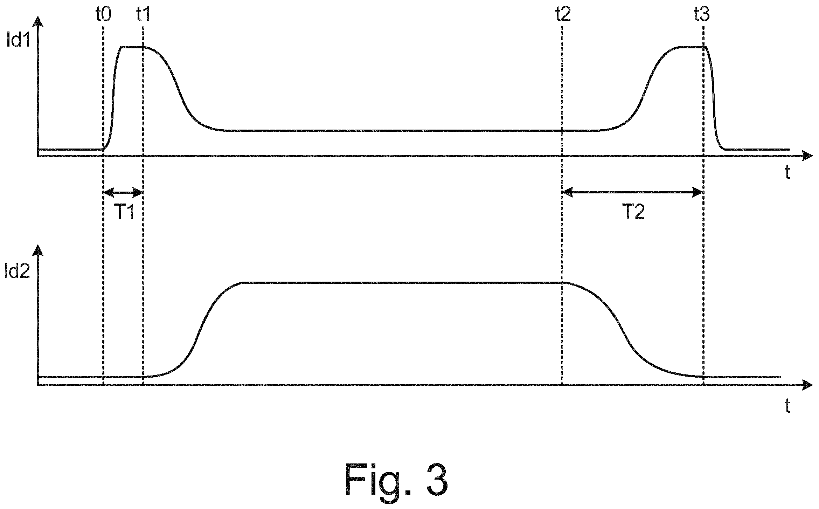

With continued reference to FIG. 2, FIG. 3 is a signal diagram illustrating drain currents for at least one switching set of converter 14. Controller 12 is configured to turn MOSFETs 30a-30n, 32a-32n, 34a-34n, and 36a-36n on and off to control power to load 18 from power source 16. Controller 12 may implement PWM or any other converter control scheme. FIG. 3 illustrates one instance of turning one switching set on and off. For example, if controller 12 implements PWM, FIG. 3 illustrates a single pulse for a single switching set. For example, current Id1 may illustrate the drain current of MOSFET 30a, and current Id2 may illustrate the drain current of MOSFET 32a.

At time t0, MOSFET 30a is turned on. As seen in FIG. 3, once MOSFET 30a is turned on, current begins to flow through MOSFET 30a to load 18. Because MOSFET 32a is turned at this time, MOSFET 30a may be sized to handle the full current to load 18 from power source 16. Once MOSFET 30a is substantially or fully turned on, controller 12 may turn on low on-resistance MOSFET 32a at time t1. The time period T1, which is the time between turn-on of MOSFET 30a and turn-on of MOSFET 32a may be any selected threshold time period that ensures that MOSFET 30a has fully, or at least substantially, turned on. For example, T1 may be expected time for which the low gate charge field effect transistor will transition from off to fully conducting. T1 may be determined using a simulation of MOSFET 30a, manufacturer specifications for MOSFET 30a, or any other method of determining a turn-on time for MOSFET 30a. For example, in another embodiment, circuitry may be added to power converter 14 to monitor the current through MOSFET 30a to determine when MOSFET 30a has substantially or fully turned on. Following T1, at time t1, MOSFET 32a is turned on to conduct current from the input power to load 18.

By turning on MOSFET 30a first, which is a low gate charge MOSFET, the switching losses for power converter 14 may be minimized. Once MOSFET 30a is fully conducting current, MOSFET 32a, which is a low Rdsₒₙ MOSFET, can be turned on. Because MOSFET 30a is already on and conducting, the greater switching losses of low Rdsₒₙ switches are not a detriment to the system. As seen in FIG. 3, once MOSFET 32a is turned on, MOSFET 32a carries the majority of current to load 18, greatly reducing power dissipation as compared to low gate charge MOSFETs.

When turning off MOSFETs 30a and 32a, MOSFET 32a, which is the low Rdsₒₙ switch, is turned off first at time t2. While MOSFET 32a is being turned off, and after turn-off, MOSFET 30a continues to conduct current to load 18. After a threshold time period T2 following turn-off of MOSFET 32a, MOSFET 30a is turned off at time t3, which terminates current to load 18. The time period T2, which is the time between turn-off of MOSFET 32a and turn-off of MOSFET 30a may be any selected threshold time period that ensures that MOSFET 32a has substantially or fully turned off. For example, T2 may be an expected time for which the low on-resistance field effect transistor will transition from fully conducting to off. T2 may be determined using a simulation of MOSFET 32a, manufacturer specifications for MOSFET 32a, or any other method of determining a turn-off time for MOSFET 32a. For example, in another embodiment, circuitry may be added to power converter 14 to monitor the current through MOSFET 32a to determine when MOSFET 32a has fully turned off. Following T2, at time t3, MOSFET 32a is turned off to fully terminate power to load 18 through the first switching set.

By turning off MOSFET 32a first, which is a low Rdsₒₙ MOSFET, the switching losses for power converter 14 may be minimized. Once MOSFET 32a is fully turned off, MOSFET 30a, which is a low gate charge MOSFET, can be turned off. Because MOSFET 32a is already off, the greater switching losses of low Rdsₒₙ switches are not a detriment to the system. By controlling MOSFETs 30a and 32a in this way, the overall power dissipation for the first switching set of converter 14 can be reduced. This method can also be applied to the second switching set of converter 14 to further reduce power dissipation and switching losses for converter 14.

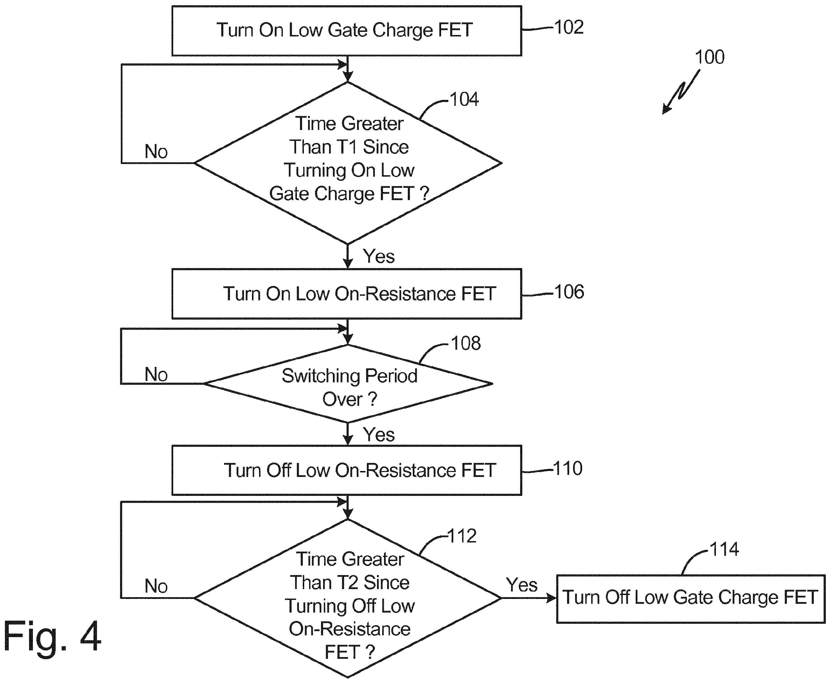

FIG. 4 is a flowchart illustrating method 100 of turning switches in a power converter on and off to minimize conduction losses within the power converter. The power converter may be any type of power converter and switches of the power converter are turned on and off by a controller in order to control power to the load. For example, the power converter may be the buck converter illustrated in FIG. 2. At step 102, the controller determines that a switching set of the converter needs to be turned on. This may be based on any converter control scheme such as, but not limited to, PWM. Each switching set of the converter includes two types of switches connected in parallel. The first type of switch may be a low gate charge field effect transistor (FET), and the second type of switch may be a low on-resistance FET. The controller begins by turning on the low gate charge FET at step 102.

Following turn-on of the low gate charge FET at step 102, method 100 remains at step 104 until a first threshold time period T1 has elapsed. Following the threshold time period T1, at step 106, the controller turns on the low on-resistance FET to carry the majority of current to the load. Method 100 remains at step 108 for the duration of the switching period. Both switches remain on during step 108. At step 110, which may be the end of a pulse for PWM control, for example, the low on-resistance FET is turned off. Following turn-off of the low on-resistance FET at step 110, method 100 remains at step 112 until a second threshold time period T2 has elapsed. Following the second threshold time period T2, at step 114, the controller turns off the low gate charge FET to terminate power to the load through the respective switching set.

Method 100 is performed for each switching set of the power converter each time the switching set is turned on and then off. For example, in a full H-bridge converter, all four switching sets of the converter will each include at least one low gate charge FET connected in parallel with at least one low on-resistance FET. This allows switching losses for the entire power converter to be reduced at turn-on and turn-off, while also reducing power dissipation for the entire power converter between turn-on and turn-off.

### Discussion of possible embodiments

The following are non-exclusive descriptions of possible embodiments of the present invention.

A method of controlling a power converter that includes at least one first switch of a first switch type and at least one second switch of a second switch type, includes converting, by the power converter, an input power at a converter input into output power at a converter output for a load. Converting the input power into the output power includes turning on, by a controller, the at least one first switch to conduct current from the converter input to the converter output; and turning on, by the controller, the at least one second switch to conduct current from the converter input to the converter output after a first threshold time period following turn-on of the at least one first switch.

The method of the preceding paragraph can optionally include, additionally and/or alternatively, any one or more of the following features, configurations and/or additional components:

A further embodiment of the foregoing method, wherein converting, by the power converter, the input power to the output power further includes turning off, by the controller, the at least one second switch; and turning off, by the controller, the at least one first switch to terminate current flow from the converter input to the converter output after a second threshold time period following turn-off of the at least one second switch.

A further embodiment of any of the foregoing methods, wherein the first switch type is a low gate charge field effect transistor.

A further embodiment of any of the foregoing methods, wherein the second switch type is a low on-resistance field effect transistor.

A further embodiment of any of the foregoing methods, wherein the first threshold time period comprises an expected time for which the low gate charge field effect transistor will transition from off to substantially or fully conducting.

A further embodiment of any of the foregoing methods, wherein the second threshold time period comprises an expected time for which the low on-resistance field effect transistor will transition from fully conducting to off.

A further embodiment of any of the foregoing methods, wherein the at least one first switch comprises a plurality of first switches, and wherein the at least one second switch comprises a plurality of second switches each connected in parallel with the plurality of first switches, and wherein converting the input power into the output power further includes turning on, by the controller, each of the plurality of first switches to conduct the current from the converter input to the converter output; and turning on, by the controller, each of the plurality of second switches to conduct current from the converter input to the converter output after the first threshold time period following turn-on of each of the plurality of first switches.

A further embodiment of any of the foregoing methods, wherein turning on, by the controller, each of the plurality of first switches includes providing a common gate drive signal to each of the plurality of first switches.

A further embodiment of any of the foregoing methods, wherein turning on, by the controller, each of the plurality of second switches includes providing a common gate drive signal to each of the plurality of second switches.

A method of controlling power from an input power to a load includes turning on, by a controller, one or more first switches to conduct current from the input power to the load, wherein each of the one or more first switches are of a first switch type; and turning on, by the controller, one or more second switches, connected in parallel with the one or more first switches, to conduct current from the input power to the load after a first threshold time period following turn-on of the one or more first switches, wherein each of the one or more second switches are of a second switch type different from the first switch type.

The method of the preceding paragraph can optionally include, additionally and/or alternatively, any one or more of the following features, configurations and/or additional components:

A further embodiment of the foregoing method, further including turning off, by the controller, the one or more second switches; and turning off, by the controller, the one or more first switches to terminate current flow from the input power to the load after a second threshold time period following turn-off of the one or more second switches.

A further embodiment of any of the foregoing methods, wherein the first switch type is a low gate charge field effect transistor.

A further embodiment of any of the foregoing methods, wherein the second switch type is a low on-resistance field effect transistor.

A further embodiment of any of the foregoing methods, wherein the first threshold time period comprises an expected time for which the low gate charge field effect transistor will transition from off to substantially or fully conducting.

A further embodiment of any of the foregoing methods, wherein the second threshold time period comprises an expected time for which the low on-resistance field effect transistor will transition from fully conducting to off.

A further embodiment of any of the foregoing methods, wherein the one or more first switches comprise a plurality of first switches, and wherein the one or more second switches comprise a plurality of second switches each connected in parallel with the plurality of first switches, and wherein turning on, by the controller, the one or more first switches to conduct the current from the input power to the load comprises turning on, by the controller, each of the plurality of first switches to conduct the current from the input power to the load, and wherein turning on, by the controller, the one or more second switches to conduct current from the input power to the load comprises turning on, by the controller, each of the plurality of second switches to conduct current from the input power to the load after the first threshold time period.

A further embodiment of any of the foregoing methods, wherein turning on, by the controller, each of the plurality of first switches includes providing a common gate drive signal to each of the plurality of first switches.

A further embodiment of any of the foregoing methods, wherein turning on, by the controller, each of the plurality of second switches includes providing a common gate drive signal to each of the plurality of second switches.

A power converter system is configured to convert an input power into an output power for a load and includes a controller, at least one low gate charge switch, and at least one low on-resistance switch connected in parallel with the at least one low gate charge switch. The controller is configured to turn the at least one gate charge switch and the at least one low on-resistance switch on and off to convert the input power to the output power, and turn on the at least one low gate charge switch and the at least one low on-resistance switch by turning on the at least one low gate charge switch, waiting a first threshold time period, and then turning on the at least one low on-resistance switch.

A further embodiment of the foregoing power converter system, wherein the controller is configured to turn off the at least one low gate charge switch and the at least one low on-resistance switch by turning off the at least one low on-resistance switch, waiting a second threshold time period, and then turning off the at least one low gate charge switch.

While the invention has been described with reference to an exemplary embodiment(s), it will be understood by those skilled in the art that various changes may be made and equivalents may be substituted for elements thereof without departing from the scope of the invention as defined by the claims. In addition, many modifications may be made to adapt a particular situation or material to the teachings of the invention without departing from the scope of the invention. Therefore, it is intended that the invention not be limited to the particular embodiment(s) disclosed, but that the invention will include all embodiments falling within the scope of the appended claims.

## Claims

1. A method of controlling a power converter that includes at least one first switch (30, 34) of a first switch type and at least one second switch (32, 36) of a second switch type, the method comprising:
converting, by the power converter (14), an input power at a converter input into output power at a converter output for a load, wherein converting the input power into the output power comprises:
turning on, by a controller (12), the at least one first switch to conduct current from the converter input to the converter output; and
turning on, by the controller, the at least one second switch to conduct current from the converter input to the converter output after a first threshold time period following turn-on of the at least one first switch.

2. The method of claim 1, wherein converting, by the power converter, the input power to the output power further comprises:
turning off, by the controller, the at least one second switch; and
turning off, by the controller, the at least one first switch to terminate current flow from the converter input to the converter output after a second threshold time period following turn-off of the at least one second switch.

3. The method of claim 1 or 2, wherein the at least one first switch comprises a plurality of first switches, and wherein the at least one second switch comprises a plurality of second switches each connected in parallel with the plurality of first switches, and wherein converting the input power into the output power further comprises:
turning on, by the controller, each of the plurality of first switches to conduct the current from the converter input to the converter output; and
turning on, by the controller, each of the plurality of second switches to conduct current from the converter input to the converter output after the first threshold time period following turn-on of each of the plurality of first switches.

4. The method of claim 3, wherein turning on, by the controller, each of the plurality of first switches comprises providing a common gate drive signal to each of the plurality of first switches.

5. The method of claim 3, wherein turning on, by the controller, each of the plurality of second switches comprises providing a common gate drive signal to each of the plurality of second switches.

6. A method of controlling power from an input power to a load, the method comprising:
turning on, by a controller, one or more first switches to conduct current from the input power to the load, wherein each of the one or more first switches are of a first switch type; and
turning on, by the controller, one or more second switches, connected in parallel with the one or more first switches, to conduct current from the input power to the load after a first threshold time period following turn-on of the one or more first switches, wherein each of the one or more second switches are of a second switch type different from the first switch type.

7. The method of claim 6, further comprising:
turning off, by the controller, the one or more second switches; and
turning off, by the controller, the one or more first switches to terminate current flow from the input power to the load after a second threshold time period following turn-off of the one or more second switches.

8. The method of claim 6 or 7, wherein the one or more first switches (30, 34) comprise a plurality of first switches, and wherein the one or more second switches (32, 36) comprise a plurality of second switches each connected in parallel with the plurality of first switches, and wherein turning on, by the controller, the one or more first switches to conduct the current from the input power to the load comprises turning on, by the controller, each of the plurality of first switches to conduct the current from the input power to the load, and wherein turning on, by the controller, the one or more second switches to conduct current from the input power to the load comprises turning on, by the controller, each of the plurality of second switches to conduct current from the input power to the load after the first threshold time period.

9. The method of claim 8, wherein turning on, by the controller, each of the plurality of first switches comprises providing a common gate drive signal to each of the plurality of first switches, or wherein turning on, by the controller, each of the plurality of second switches comprises providing a common gate drive signal to each of the plurality of second switches.

10. The method of any preceding claim, wherein the first switch type is a low gate charge field effect transistor.

11. The method of claim 10, wherein the second switch type is a low on-resistance field effect transistor.

12. The method of claim 10, wherein the first threshold time period comprises an expected time for which the low gate charge field effect transistor will transition from off to substantially or fully conducting.

13. The method of claim 11, wherein the second threshold time period comprises an expected time for which the low on-resistance field effect transistor will transition from fully conducting to off.

14. A power converter system configured to convert an input power into an output power for a load, the system comprising:
at least one low gate charge switch (30, 34);
at least one low on-resistance switch (32, 36) connected in parallel with the at least one low gate charge switch; and
a controller (12) configured to turn the at least one gate charge switch and the at least one low on-resistance switch on and off to convert the input power to the output power, wherein the controller is configured to turn on the at least one low gate charge switch and the at least one low on-resistance switch by turning on the at least one low gate charge switch, waiting a first threshold time period, and then turning on the at least one low on-resistance switch.

15. The power converter system of claim 14, wherein the controller is configured to turn off the at least one low gate charge switch and the at least one low on-resistance switch by turning off the at least one low on-resistance switch, waiting a second threshold time period, and then turning off the at least one low gate charge switch.
